# EUROPÄISCHE PATENTSCHRIFT

(11) **EP 1 219 151 B1**
(45) Veröffentlichungstag und Bekanntmachung des Hinweises auf die Patenterteilung: **17.11.2004**
(21) Anmeldenummer: 00981137.3
(22) Anmeldetag: 28.09.2000
(51) Int. Cl.: H05K 9/00

(54) **ELEKTRISCHES GERÄT MIT IN EINEM GEHÄUSE ANGEORDNETEN UND NACH AUSSEN ELEKTROMAGNETISCH ABGESCHIRMTEN KOMPONENTEN**
ELECTRICAL DEVICE COMPRISING COMPONENTS WHICH ARE ARRANGED IN A CASING AND ARE ELECTROMAGNETICALLY SHIELDED IN AN OUTWARD MANNER
APPAREIL ELECTRIQUE COMPORTANT DES ELEMENTS DISPOSES DANS UN BOITIER ET MUNIS D'UNE PROTECTION ELECTROMAGNETIQUE VIS-A-VIS DE L'EXTERIEUR

(30) Priorität: 30.09.1999 DE 19947130
(43) Veröffentlichungstag der Anmeldung: 03.07.2002
(73) Patentinhaber: SIEMENS AKTIENGESELLSCHAFT, 80333 München (DE); DMT GMBH, 71088 Holzgerlingen (DE)
(72) Erfinder: LUDWIG, Michael, 76199 Karlsruhe (DE); LINDMÜLLER, Peter, 76879 Essingen (DE); SCHWEGLER, Tim, 71069 Sindelfingen (DE)
(86) Internationale Anmeldenummer: PCT/DE2000/003427
(87) Internationale Veröffentlichungsnummer: WO 2001/026439

(56) Entgegenhaltungen:
- EP-A- 0 667 643
- EP-A- 0 785 557
- US-A- 4 408 255

## Beschreibung

Elektrisches Gerät mit in einem Gehäuse angeordneten und nach außen elektromagnetisch abgeschirmten Komponenten

Die Erfindung betrifft ein elektrisches Gerät mit in einem Gehäuse angeordneten und nach außen elektromagnetisch abgeschirmten Komponenten.

Bei einem derartigen, aus der US 5 539 148 bekannten elektrischen Gerät trägt die Innenwand des Plastikgehäuses von außen nach innen eine leitfähige Schicht und eine Schicht mit Ferriten, die in einem Harz eingebunden sind. Dadurch wird im Gehäuseinneren elektromagnetische Strahlung an der leitenden Schicht reflektiert und in der die Ferrite enthaltenden Schicht gedämpft.

Aus der US 4 699 743 ist es bekannt, mit Ferriten gefülltes plastisches Material als Abschirmung auf elektrische Bauelemente aufzuschrumpfen.

Aus der Zusammenfassung der JP 59-227920 A1 ist mit Ferriten gefüllter Polyurethanschaum zur Absorption elektromagnetischer Wellen bekannt. Entsprechende pyramiden- oder pyramidenstumpfförmige Schaumstoffteile werden bekanntermaßen als Innenwandverkleidung von EMV-Kabinen benutzt, in denen u. a. die elektromagnetische Verträglichkeit von elektrischen Geräten getestet wird.

Aus der US 5 682 289 ist ein Gehäusekonzept bekannt, bei dem die Komponenten von elektrischen Geräten formschlüssig in entsprechenden Ausnehmungen von Kunststoff-Formteilen, vorzugsweise aus Schaumstoffen wie Polyurethan oder expandiertes Polypropylen (EPP), gehalten sind. Dieses Gehäusekonzept ist auch unter der Bezeichnung E-PAC® bekannt.

Der Erfindung liegt die Aufgabe zugrunde, mit möglichst einfachen Mitteln eine wirkungsvolle elektromagnetische Abschirmung von Komponenten elektrischer Geräte zu erreichen.

Gemäß der Erfindung wird die Aufgabe dadurch gelöst, daß bei dem elektrischen Gerät der eingangs angegebenen Art in dem Gehäuse zwischen diesem und den Komponenten sowie zwischen den Komponenten vorhandene Zwischenräume durch mit Ferritpartikeln versehene Kunststoffteile ausgefüllt sind. Im Unterschied zu den bekannten Abschirmmaßnahmen bei elektrischen Geräten erfolgt die Dämpfung der elektromagnetischen Strahlung nicht an einer z. B. durch eine Schicht oder eine Gehäusewand ausgebildeten Grenzfläche zwischen dem Geräteinneren und der Außenumgebung, sondern im Geräteinneren und ist somit besonders wirkungsvoll. Darüber hinaus wirkt die Abschirmung nicht nur nach außen, sondern auch innerhalb des Gerätes zwischen den durch die mit den Ferritpartikeln versehenen Kunststoffteile voneinander getrennten Komponenten. Da die Ferritpartikel nichtleitend sind, können die einzelnen Komponenten des elektrischen Geräts unmittelbar an den Kunststoffteilen anliegen, ohne daß dabei die Spannungsfestigkeit des elektrischen Geräts beeinträchtigt wird oder es gar zu Kurzschlüssen kommt.

Entsprechend dem aus der oben erwähnten US 5 682 289 bekannten Gehäusekonzept werden die Kunststoffteile vorzugsweise von die Zwischenräume ausfüllenden Bereichen mindestens eines Kunststoff-Formteils gebildet, in dem die Komponenten formschlüssig gehalten sind. Alternativ handelt es sich bei den Kunststoffteilen um die Zwischenräume ausfüllende, z. B. kugelförmige, Füllkörper.

Ebenso wie bei dem bekannten E-PAC®-Konzept bestehen die Kunststoffteile bzw. Kunststoff-Formteile vorzugsweise aus Schaumstoff.

Die Kunststoffteile können außen in vorgegebenen Bereichen mit den Ferritpartikeln beschichtet sein. Vorzugsweise beinhalten die Kunststoffteile die Ferritpartikel, so daß die Dämpfung räumlich und somit besonders wirkungsvoll erfolgt. Die äußere Beschichtung der Kunststoffteile mit den Ferritpartikeln ist dabei zusätzlich möglich.

Die Beladung der Kunststoffteile mit den Ferritpartikeln erfolgt vor der Formgebung, also z. B. durch Beimischung zu dem Polymer oder vor dessen Aufschäumen. Für den Fall, daß die Kunststoffteile wie z. B. bei expandiertem Polypropylen durch Verschmelzen von Kunststoffperlen gebildet werden, werden die Kunststoffperlen vorzugsweise zuvor mit den Ferritpartikeln beschichtet, z. B. aufgetrommelt. Für eine wirkungsvolle elektromagnetische Dämpfung im interessierenden Frequenzbereich zwischen 80 und 300 MHz hat sich eine Beladung der Kunststoffteile mit den Ferritpartikeln in einem Volumenanteil von 2 bis 10 % als vorteilhaft herausgestellt.

Das Gehäuse des elektrischen Geräts ist vorzugsweise außen elektrisch leitend, um so im wesentlichen ein Eindringen elektromagnetischer Strahlung in das Gehäuseinnere bzw. das Abstrahlen von elektromagnetischer Strahlung aus dem Gehäuse heraus zu verhindern. Über Gehäuseöffnungen oder Leitungsdurchführungen können jedoch bei einigen Frequenzen elektromagnetische Felder eindringen, für die das Gehäuse einen Hohlraumresonator bildet. Durch die mit den Ferritpartikeln versehenen Kunststoffteile werden insbesondere durch Resonanz überhöhte elektromagnetische Felder bedeutend gedämpft. Elektromagnetische Felder mit Frequenzen außerhalb von Resonanzen werden von dem leitfähigen Gehäuse reflektiert. Im einfachsten Falle handelt es sich bei dem elektrisch leitenden Gehäuse um ein Metallgehäuse, in dessen Inneren die Komponenten des elektrischen Geräts zusammen mit den Kunststoffteilen angeordnet sind. Bei der Verwendung von Kunststoff-Formteilen können die jeweils außen liegenden Kunststoff-Formteile aber auch selbst das Gehäuse bilden und erforderlichenfalls an der Außenseite elektrisch leitend beschichtet sein.

Zur weiteren Erläuterung der Erfindung zeigen
- Figur 1: ein erstes Ausführungsbeispiel und
- Figur 2: ein zweites Ausführungsbeispiel des erfindungsgemäßen elektrischen Geräts mit Kunststoff-Formteilen;
- Figur 3: zeigt ein weiteres Ausführungsbeispiel des Geräts mit als Füllkörper dienenden Kunststoffteilen.

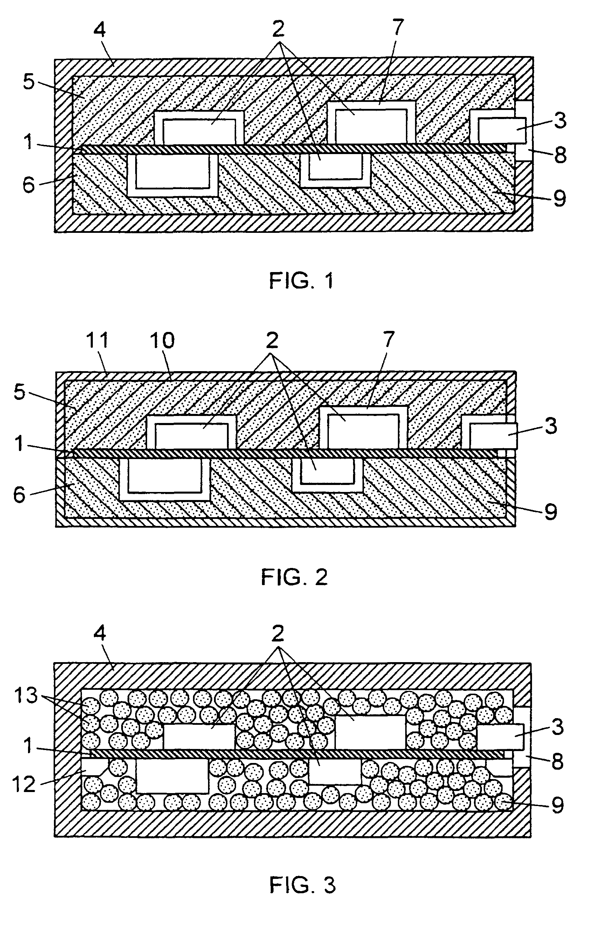

Figur 1 zeigt in schematischer Darstellung ein elektrisches Gerät, dessen Komponenten aus einer Leiterplatte 1 mit darauf angeordneten elektrischen Bauelementen 2 einschließlich eines Steckverbinders 3 bestehen. Die Komponenten 1, 2 und 3 des elektrischen Geräts sind innerhalb eines Metallgehäuses 4 zusammen mit zwei Kunststoff-Formteilen 5 und 6 angeordnet, wobei die Komponenten 1, 2 und 3 in entsprechenden Ausnehmungen 7 der Kunststoff-Formteile 5 und 6 formschlüssig gehalten werden. Der Steckverbinder 3 ist durch eine Öffnung 8 in dem Metallgehäuse 4 von außen her zugänglich, so daß elektromagnetische Strahlung durch diese Öffnung 8 in das Gehäuseinnere eindringen kann. Zur Absorption dieser in das Gehäuseinnere eindringenden Strahlung aber auch der von dem elektrischen Gerät selbst abgestrahlten elektromagnetischen Strahlung sind die Kunststoff-Formteile 5 und 6 mit Ferritpartikeln 9 in Form von Ferritpulver zu einem Volumenanteil von 2 bis 10 % gefüllt.

Das in Figur 2 gezeigte Ausführungsbeispiel des erfindungsgemäßen elektrischen Geräts unterscheidet sich von dem nach Figur 1 dadurch, daß anstelle des Metallgehäuses 4 die Kunststoff-Formteile 5 und 6 nach außen selbst ein Gehäuse 10 bilden. Um zu erreichen, daß das Gehäuse 10 außen elektrisch leitend ist, sind die Kunststoffteile 5 und 6 außen mit einer elektrisch leitenden Schicht 11 versehen.

Bei dem in Figur 3 gezeigten Ausführungsbeispiel ist die Leiterplatte 1 mit Hilfe von Befestigungselementen 12 in dem Metallgehäuse 4 gehalten. Zur Absorption der elektromagnetischen Strahlung sind die Zwischenräume zwischen dem Gehäuse 4 und den Komponenten 1, 2 und 3 sowie zwischen den Komponenten 1, 2 und 3 selbst durch gleichförmige Kunststoffteile 13 ausgefüllt, die mit den Ferritpartikeln 9 beladen sind.

## Patentansprüche

1. Elektrisches Gerät mit in einem Gehäuse (4, 10) angeordneten und nach außen elektromagnetisch abgeschirmten Komponenten (1, 2, 3), **dadurch gekennzeichnet, daß** in dem Gehäuse (4, 10) zwischen diesem und den Komponenten sowie zwischen den Komponenten (1, 2, 3) vorhandene Zwischenräume durch mit Ferritpartikeln (9) versehene Kunststoffteile (5, 6; 13) ausgefüllt sind.

2. Elektrisches Gerät nach Anspruch 1, **dadurch gekennzeichnet, daß** die Kunststoffteile von die Zwischenräume ausfüllenden Bereichen mindestens eines Kunststoff-Formteils (5, 6) gebildet werden, in dem die Komponenten (1, 2, 3) formschlüssig gehalten sind.

3. Elektrisches Gerät nach einem der vorangehenden Ansprüche, **dadurch gekennzeichnet, daß** die Kunststoffteile (5, 6; 13) aus Schaumstoff bestehen.

4. Elektrisches Gerät nach einem der vorangehenden Ansprüche, **dadurch gekennzeichnet, daß** die Kunststoffteile (5, 6; 13) außen in vorgegebenen Bereichen mit den Ferritpartikeln (9) beschichtet sind.

5. Elektrisches Gerät nach einem der vorangehenden Ansprüche, **dadurch gekennzeichnet, daß** die Kunststoffteile (5, 6; 13) die Ferritpartikel (9) beinhalten.

6. Elektrisches Gerät nach Anspruch 5, **dadurch gekennzeichnet, daß** die Kunststoffteile (5, 6; 13) aus miteinander verschmolzenen und zuvor mit den Ferritpartikeln (9) beschichteten Kunststoffperlen bestehen.

7. Elektrisches Gerät nach Anspruch 5 oder 6, **dadurch gekennzeichnet, daß** die Kunststoffteile (5, 6; 13) mit den Ferritpartikeln (9) in einem Volumenanteil von 2 bis 10 % beladen sind.

8. Elektrisches Gerät nach einem der vorangehenden Ansprüche, **dadurch gekennzeichnet, daß** das Gehäuse (4, 10) außen elektrisch leitend ist.

9. Elektrisches Gerät nach einem der Ansprüche 2 bis 8, **dadurch gekennzeichnet, daß** die jeweils außen liegenden Kunststoff-Formteile (5, 6) das Gehäuse (10) bilden.

## Claims

1. Electrical device comprising components which are arranged in a casing (4, 10) and are electromagnetically shielded in an outward manner (1, 2, 3), **characterized in that** in the casing (4, 10) the spaces between the casing and components and between the components themselves (1, 2, 3) are filled with plastic parts (5, 6; 13) provided with ferrite particles (9).

2. Electrical device in accordance with Claim 1, **characterised in that** the plastic parts of the areas with the spaces to be filled form at least one plastic shaped part (5, 6) in which the components (1, 2, 3) are held in a form fit.

3. Electrical device in accordance with one of the preceding Claims, **characterised in that** the plastic parts (5, 6; 13) consist of foam.

4. Electrical device in accordance with one of the preceding Claims, **characterised in that** the plastic parts (5, 6; 13) are externally coated in the specified areas with ferrite particles (9).

5. Electrical device in accordance with one of the preceding Claims, **characterised in that** the plastic parts (5, 6; 13) contain the ferrite particles (9).

6. Electrical device in accordance with Claim 5, **characterised in that** the plastic parts (5, 6; 13) consist of plastic beads fused together and coated in advance with ferrite particles (9).

7. Electrical device in accordance with Claim 5 or 6, **characterised in that** the plastic parts (5, 6; 13) are loaded with ferrite particles (9) amounting to 2 to 10% by volume.

8. Electrical device in accordance with one of the preceding Claims, **characterised in that** the casing (4, 10) is conducting in an outward manner.

9. Electrical device in accordance with one of Claims 1 to 8, **characterised in that** the outer plastic shaped parts (5, 6) in each case form the casing (10).

## Revendications

1. Appareil électrique comprenant des éléments (1, 2, 3) disposés dans un boîtier (4, 10) et protégés électromagnétiquement vis-à-vis de l'extérieur, **caractérisé en ce que** des espaces intermédiaires présents dans le boîtier (4, 10) entre celui-ci et les éléments ainsi qu'entre les éléments (1, 2, 3) sont emplis de pièces (5, 6; 13) en matière plastique munies de particules (9) de ferrite.

2. Appareil électrique suivant la revendication 1, **caractérisé en ce que** les pièces en matière plastique sont formées de zones, remplissant les espaces intermédiaires, d'au moins une pièce (5, 6) moulée en matière plastique, dans laquelle les éléments (1, 2, 3) sont maintenus par complémentarité de forme.

3. Appareil électrique suivant l'une des revendications précédentes, **caractérisé en ce que** les pièces (5, 6; 13) en matière plastique sont en matière alvéolaire.

4. Appareil électrique suivant l'une des revendications précédentes, **caractérisé en ce que** les pièces (5, 6; 13) en matière plastique sont revêtues extérieurement, dans des zones données à l'avance, par les particules (9) de ferrite.

5. Appareil électrique suivant l'une des revendications précédentes, **caractérisé en ce que** les pièces (5, 6; 13) en matière plastique contiennent les particules (9) de ferrite.

6. Appareil électrique suivant la revendication 5, **caractérisé en ce que** les pièces (5, 6; 13) en matière plastique sont constituées de perles en matière plastique fondues les unes avec les autres et revêtues au préalable des particules (9) de ferrite.

7. Appareil électrique suivant la revendication 5 ou 6, **caractérisé en ce que** les pièces (5, 6; 13) en matière plastique sont chargées des particules (9) de ferrite en une proportion en volume de 2 à 10%.

8. Appareil électrique suivant l'une des revendications précédentes, **caractérisé en ce que** le boîtier (4,10) est extérieurement conducteur de l'électricité.

9. Appareil électrique suivant l'une des revendications 2 à 8, **caractérisé en ce que** les pièces (5, 6) moulées en matière plastique, se trouvant respectivement à l'extérieur, forment le boîtier (10).
